# EUROPÄISCHE PATENTSCHRIFT

(11) **EP 1 285 408 B1**
(45) Veröffentlichungstag und Bekanntmachung des Hinweises auf die Patenterteilung: **01.03.2006**
(21) Anmeldenummer: 01929590.6
(22) Anmeldetag: 20.04.2001
(51) Int. Cl.: G06T 7/00, G01R 31/309, H05K 13/00

(54) **VERFAHREN UND VORRICHTUNG ZUM UNTERSUCHEN EINES VORBESTIMMTEN BEREICHS EINER LEITERPLATTE**
METHOD AND DEVICE FOR EXAMINING A PRE-DETERMINED AREA OF A PRINTED CIRCUIT BOARD
PROCEDE ET DISPOSITIF POUR EXAMINER UNE ZONE PREDETERMINEE D'UN CIRCUIT IMPRIME

(30) Priorität: 24.05.2000 DE 10025751
(43) Veröffentlichungstag der Anmeldung: 26.02.2003
(73) Patentinhaber: atg test systems GmbH & Co. KG, 97877 Wertheim (DE)
(72) Erfinder: ROMANOV, Victor, 97877 Wertheim (DE); BIAZIK, Andrej, PL-97-200 Tomaszow Mazowiecki (PL); PIECEK, Mariusz, PL-02-798 Warschau (PL)
(74) Vertreter: Ganahl, Bernhard
(86) Internationale Anmeldenummer: PCT/EP2001/004518
(87) Internationale Veröffentlichungsnummer: WO 2001/091053

(56) Entgegenhaltungen:
- EP-A- 0 386 924
- US-A- 5 048 094
- US-A- 5 369 431
- US-A- 5 513 099

## Beschreibung

Die vorliegende Erfindung betrifft ein Verfahren zum Untersuchen einer Leiterplatte an einem vorbestimmten Bereich der Leiterplatte und eine Vorrichtung zum Durchführen des Verfahrens.

Aus der US 4,469,553 geht eine Vorrichtung zum Bestücken, Testen und Reparieren von Leiterplatten hervor. Diese Vorrichtung weist eine Arbeitsfläche zum Aufnehmen und Halten einer zu bestückenden Leiterplatte auf. An dieser Haltefläche wird die Leiterplatte beispielsweise mittels Saugelementen fixiert. Ein Stück oberhalb der Arbeitsfläche ist ein halbdurchlässiger Spiegel angeordnet. Über dem halbdurchlässigen Spiegel befindet sich ein Bildprojektor. Mit dem Bildprojektor werden Bilder der zu bestückenden Komponenten bzw. Leiterbahninformationen auf den Spiegel projiziert. Ein Benutzer der Vorrichtung, der durch den halbdurchlässigen Spiegel blickt, sieht das von der Projektionseinrichtung auf den halbdurchlässigen Spiegel projizierte Bild sowie die dahinter angeordnete Leiterplatte. Für den Benutzer ergibt sich somit der Eindruck, als ob dieses projizierte Bild auf die Leiterplatte projiziert wird und dort die Stellen markiert, die mit einem entsprechenden Schaltungskomponenten zu bestücken sind.

Die US 5, 513,099 beschreibt eine Vorrichtung zum Reparieren und Bearbeiten von Leiterplatten. Diese Vorrichtung weist eine Arbeitsfläche auf, an der eine zu untersuchende Leiterplatte befestigbar ist. Über der Arbeitsfläche ist eine Kamera angeordnet. Die Kamera befindet sich in einem in einer horizontalen Ebene verfahrbaren Schlittenmechanismus, so dass sie über einen beliebigen Punkt der zu untersuchenden Leiterplatte automatisch anordbar ist. Diese Vorrichtung weist einen Computer mit einem Bildschirm, einer Tastatur und einer Computermaus auf.

Bei dieser Vorrichtung wird eine zu untersuchende Leiterplatte auf der Arbeitsfläche befestigt und dann wird mittels der Kamera ein digitales Bild von der Leiterplatte erzeugt und am Bildschirm angezeigt. Dieses Bild wird mit sogenannten "GERBER"-Daten überlagert. Dann kann vom Bediener eine Fehlerinformation eingegeben werden, worauf die Kamera automatisch über dem Abschnitt der Leiterplatte positioniert wird, die die Fehlerinformation betrifft. Hierauf kann der Bediener die Vergrößerung des Bildes der Kamera zusammen mit dem Bild der "GERBER"-Daten erhöhen. Hierdurch kann der Bediener den relevanten Bereich in einer vergrößerten Darstellung betrachten und analysieren.

Die US 5,369,431 beschreibt eine Reparaturstation zum Überprüfen von Leiterplatten. Diese Reparaturstation weist einen automatisch verfahrbaren Arbeitstisch auf, an welchem die zu reparierende Leiterplatte befestigbar ist. Der Arbeitstisch kann in einer Ebene verfahren und gedreht werden. Über dem Arbeitstisch ist eine Kamera angeordnet, mit welcher die zu reparierende Leiterplatte erfasst wird und der zu reparierende Abschnitt automatisch mittels des Arbeitstisches ausgerichtet wird.

Die US 5,048,094 beschreibt ein Verfahren, bei welchem ein zu prüfendes Muster mittels einer Kamera abgetastet wird. Dieses Muster wird mit einem Referenzmuster verglichen, wobei vor dem Vergleich eine Winkelabweichung des eingescannten Musters gegenüber dem Referenzmuster ermittelt und entsprechend korrigiert wird.

Aus der EP 0 386 924 A2 geht eine weitere Reparaturstation hervor, die einen automatisch angetriebenen und drehbaren Arbeitstisch aufweist, wobei über dem Arbeitstisch eine Kamera mit einer Zoom-Linse zum Abtasten der zu untersuchenden Leiterplatte angeordnet ist. Eine zu reparierende Leiterplatte kann mittels des Arbeitstisches automatisch ausgerichtet werden.

Der Erfindung liegt die Aufgabe zugrunde ein Verfahren zum Untersuchen einer Leiterplatte an einem vorbestimmten Bereich der Leiterplatte und eine Vorrichtung zum Ausführen des Verfahrens zu schaffen, mit welchen schnell und einfach der vorbestimmte Bereich einer vergrößerten Darstellung aufgefunden und betrachtet werden kann, wobei die zum Ausführen des Verfahrens notwendige Vorrichtung sehr einfach und kostengünstig ausgebildet ist.

Die Aufgabe wird durch ein Verfahren mit den Merkmalen des Anspruchs 1 und durch eine Vorrichtung mit den Merkmalen des Anspruchs 12 gelöst. Vorteilhafte Ausgestaltungen der Erfindung sind in den Unteransprüchen angegeben.

Das erfindungsgemäße Verfahren zum Untersuchen einer Leiterplatte an einem vorbestimmten Bereich der Leiterplatte verwendet eine Vorrichtung, die eine stationär angeordnete Kamera und eine Anzeigeeinrichtung aufweist. Das Verfahren umfasst folgende Schritte:
a) Anordnen einer zu untersuchenden Leiterplatte im Abtastbereich der Kamera, wobei ein Kamerabild und ein vom Kamerabild unabhängiges Leiterplattenbild auf der Anzeigeeinrichtung im gleichen Maßstab dargestellt werden,
b) Verschieben der zu untersuchenden Leiterplatte, um das Kamerabild möglichst weitgehend mit dem Leiterplattenbild in Deckung zu bringen,
c) Vergrößern des Kamerabildes und des Leiterplattenbildes im gleichen Verhältnis auf der Anzeigeeinrichtung,
d) in exaktere Deckung Bringen des Kamerabildes (25) bzgl. des Leiterplattenbildes, und
e) Anzeigen des zu untersuchenden vorbestimmten Bereichs, so dass der vorbestimmte Bereich der zu untersuchenden Leiterplatte in vergrößerter Darstellung an der Anzeigeeinrichtung erkennbar ist.

Zum Ausführen des erfindungsgemäßen Verfahrens genügt es eine stationär angeordnete Kamera zu verwenden und diese an eine Anzeigeeinrichtung zu koppeln, die beispielsweise durch den Bildschirm eines handelsüblichen Computers dargestellt werden kann. Die zu untersuchende Leiterplatte wird im Abtastbereich der Kamera angeordnet und ist darin frei beweglich. Auf der Anzeigeeinrichtung wird ein Kamerabild, das das durch die Kamera erfasste Bild der Leiterplatte zeigt, und ein Leiterplattenbild, das vom Kamerabild unabhängig ist und wesentliche Grundzüge der Leiterplatte zeigt, auf der Anzeigeeinrichtung dargestellt. Das Kamerabild und das Leiterplattenbild werden jeweils im gleichen Maßstab gezeigt. Durch Verschieben der zu untersuchenden Leiterplatte wird das Kamerabild möglichst weitgehend mit dem Leiterplattenbild in Deckung gebracht. Hiernach werden das Kamerabild und das Leiterplattenbild im gleichen Verhältnis vergrößert. Durch erneutes Verschieben der Leiterplatte wird das Kamerabild noch exakter in Deckung mit dem Leiterplattenbild gebracht.

Durch dieses zumindest zweistufige Ausrichten des Kamerabildes bezüglich des Leiterplattenbildes kann eine sehr exakte Überlagerung der beiden Bilder erzielt werden, ohne dass hierzu ein hoher technischer Aufwand notwendig wäre.

Beim erfindungsgemäßen Verfahren wird somit auf einfache Weise zunächst eine Grobausrichtung durchgeführt und sobald die Grobausrichtung abgeschlossen ist eine Feinausrichtung durchgeführt, indem die zu überlappenden Bilder vergrößert werden und die Abweichungen zwischen dem Leiterplattenbild und dem Kamerabild für den Benutzer erkennbar sind, die bei dem in der Feinausrichtung verwendeten Maßstab nicht erkennbar gewesen sind. Durch das schrittweise Vergrößern kann somit die Leiterplatte lediglich durch Verschieben auf einer glatten Unterlage sehr exakt bezüglich einer stark vergrößerten Darstellung ausgerichtet werden.

Da bei einer stark vergrößerten Darstellung der Leiterplatte auf dem Bildschirm lediglich ein Ausschnitt erkennbar ist, ist es praktisch nicht möglich, eine Leiterplatte bezüglich eines solchen Ausschnittes auszurichten, wenn die Leiterplatte nicht vorab zumindest grob ausgerichtet worden ist. Das erfindungsgemäße schrittweise Ausrichten einer zu untersuchenden Leiterplatte bezüglich eines Leiterplattenbildes erlaubt deshalb eine schnelle und exakte Ausrichtung bezüglich eines stark vergrößerten Leiterplattenbildes.

Nach einem bevorzugten Ausführungsbeispiel der Erfindung werden an einem Ausschnitt der Anzeigeeinrichtung das Leiterplattenbild und das Kamerabild und an einem weiteren Ausschnitt ein CAD-Bild dargestellt. Das CAD-Bild zeigt die sichtbaren Leiterplattentestpunkte und Leiterbahnen. Die beiden Ausschnitte sind nebeneinander angeordnet und die entsprechenden Bilder (Leiterplattenbild, Kamerabild, CAD-Bild) sind alle im gleichen Maßstab dargestellt, so dass an der Anzeigeeinrichtung das Kamerabild, das ein Abbild der physikalischen Leiterplattenvorrichtung ist, und das CAD-Bild verglichen werden können und entsprechende Abweichungen als Fehler feststellbar sind.

Nach einer weiteren bevorzugten Ausführungsform der Erfindung sind in zwei weiteren Ausschnitten der Anzeigeeinrichtung eine Fehlerliste bzw. ein vollständiges Leiterplattenbild dargestellt, in welches der von der Kamera erfasste Bereich der zu untersuchenden Leiterplatte eingetragen ist.

Vorzugsweise wird eine zu untersuchende Leiterplatte in einer Leiterplattenprüfvorrichtung getestet und aufgrund der dabei durchgeführten Messung wird eine Fehlerdatei erzeugt, die eine Liste aller durch die Messungen ermittelten potentiellen Fehler beinhaltet. Diese Leiterplatte wird dann mit dem erfindungsgemäßen Verfahren untersucht, wobei der mit der Leiterplattenprüfvorrichtung ermittelte Fehlerort einen vorbestimmten zu untersuchenden Bereich der Leiterplatte darstellt. All diese Bereiche werden aufeinanderfolgend untersucht, indem die Leiterplatte zunächst grob bezüglich eines Leiterplattenbildes ausgerichtet wird und dann exakter in einer vergrößerten Darstellung des Kamerabildes und des Leiterplattenbildes ausgerichtet wird. Der zu untersuchende vorbestimmte Bereich wird auf der Anzeigeeinrichtung dargestellt, so dass der Bediener erkennen kann, welcher Bereich zu analysieren ist. Hierbei werden vorzugsweise die einzelnen Schritte mit einer einzigen Taste, die z.B. als Fußtaster ausgebildet ist, aufgerufen.

Die Erfindung wird nachfolgend beispielhaft anhand eines in den Zeichnungen dargestellten Ausführungsbeispieles näher erläutert. In den Zeichnungen zeigen:
- Fig. 1: eine perspektivische Ansicht einer erfindungsgemäßen Vorrichtung zum Untersuchen einer Leiterplatte an einem vorbestimmten Bereich der Leiterplatte,
- Fig. 2: die Vorrichtung aus Fig. 1 in einem Blockschaltbild,
- Fig. 3: das erfindungsgemäße Verfahren in einem Flussdiagramm,
- Fig. 4 a bis: 4 g Bildschirmdarstellung der einzelnen Schritte des erfindungsgemäßen Verfahrens nach Fig. 3, und
- Fig.5: ein Blockschaltbild das den Produktionsablauf zum Herstellen von Leiterplatten beginnend mit dem Entwurf der Leiterplatten bis zum abschließenden Untersuchen der Leiterplatten mit dem erfindungsgemäßen Verfahren zeigt.

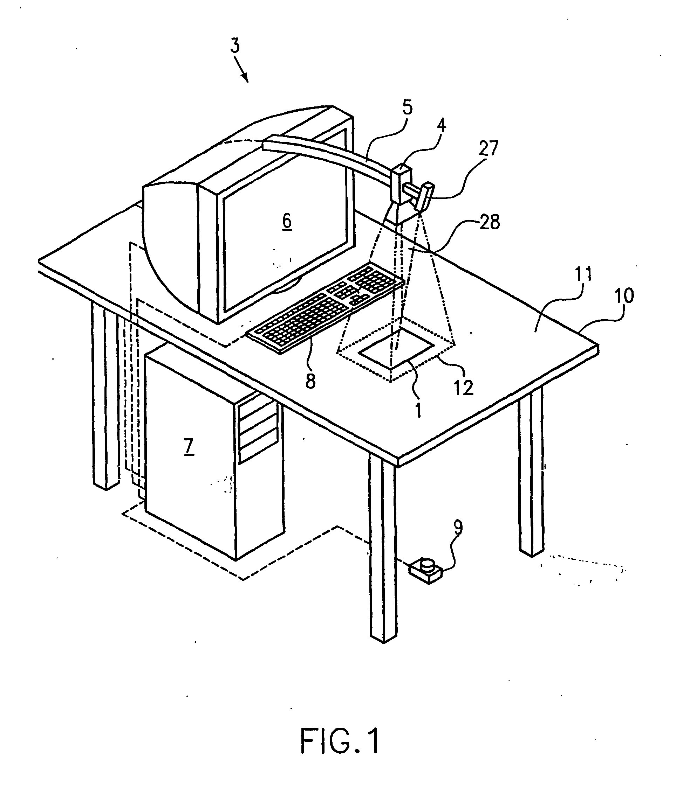

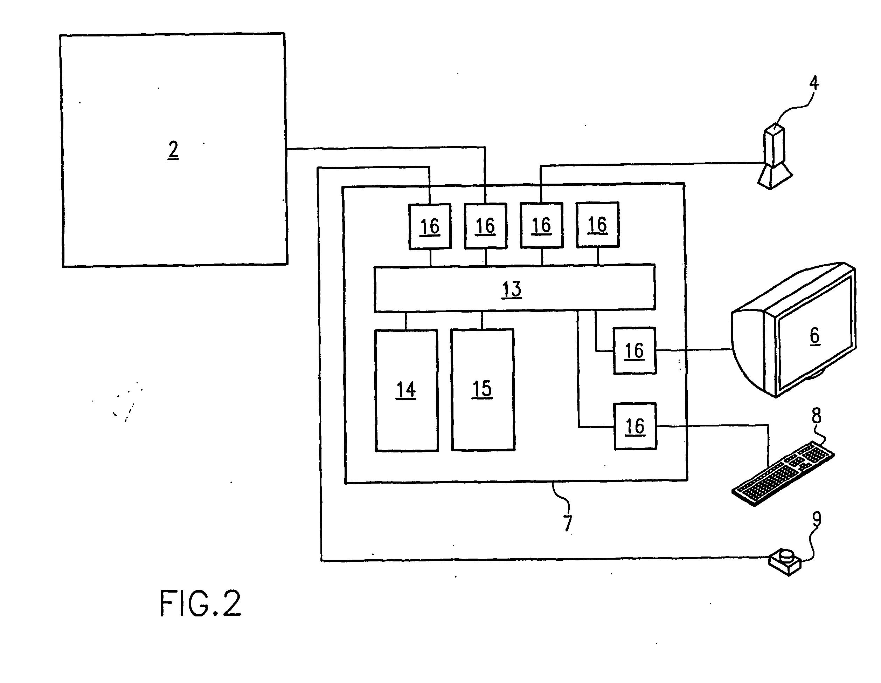

Mit den nachfolgend näher erläuterten Ausführungsbeispiel des erfindungsgemäßen Verfahrens zum Untersuchen einer Leiterplatte 1 (Fig. 1) sollen Fehler der Leiterplatte, die mittels einer Leiterplattenprüfvorrichtung 2 (Fig. 2) einem Anwender des erfindungsgemäßen Verfahrens schnell und einfach in vergrößerter Darstellung sichtbar gemacht werden. Hierzu wird eine Prüfvorrichtung 3 verwendet, die in Fig. 1 in perspektivischer Darstellung und in Fig. 2 in einem Blockschaltbild schematisch dargestellt ist.

Die Leiterplattentestvorrichtung 2 kann ein Paralleltester sein, wie er z.B. aus der EP 0 875 767 A2 oder ein Fingertester sein, wie er in der EP 0 468 153 A1 bzw. EP 0 853 242 A1 beschrieben ist.

Die Prüfvorrichtung weist eine stationär angeordnete Kamera 4 auf, die im vorliegenden Ausführungsbeispiel mittels einer Haltestange 5 am oberen Randbereich eines Bildschirms 6 befestigt ist. An der Haltestange 5 ist neben der Kamera 4 optional ein Lichtzeiger 27 befestigt, der einen gebündelten Lichtstrahl 28 aussendet. Die Kamera 4 und der Bildschirm 6 sind elektrisch mit einem Computer 7 verbunden. Am Computer 7 sind weiterhin eine Tastatur 8 und ein Fußtaster 9 angeschlossen. Der Bildschirm 6 ist mit der Kamera 4 auf einem Tisch 10 angeordnet, dessen Tischplatte 11 die Arbeitsfläche zum Auflegen der zu untersuchenden Leiterplatte 1 bildet. Die Kamera 4 ist ein Stück oberhalb der Tischplatte 11 angeordnet und mit ihrem Abtastbereich 12 auf die Tischplatte 11 gerichtet.

Der Computer 7 ist ein handelsüblicher Personalcomputer mit einem Datenbus 13, an dem eine CPU-Einheit 14 und ein Datenspeicher 15 angeschlossen sind. Ferner sind an dem Datenbus 13 Interfaceeinrichtungen 16 angeschlossen, die jeweils eine Schnittstelle zur Tastatur 8, zum Bildschirm 6, zur Kamera 4 und zum Fußtaster 9 bilden. Weiterhin ist der Computer 7 über eine Interfaceeinrichtung 16 mit der Leiterplattentestvorrichtung 2 verbunden.

Die Kamera 4 ist eine CCD-Kamera mit einer Auflösung von 752 x 582 Bildpunkten. Sie besitzt ein elektrisch ansteuerbares Zoomobjektiv, das über einen Brennweitenbereich von 4,1 mm bis 73,8 mm verfügt. Als Kamera kann z.B. eine Kamera des Typs FCB-1X47P von SONY verwendet werden. Derartige Kameras sind Serienprodukte und deshalb kostengünstig und einfach erhältlich.

Der Lichtzeiger 27 ist vorzugsweise als Laser ausgebildet.

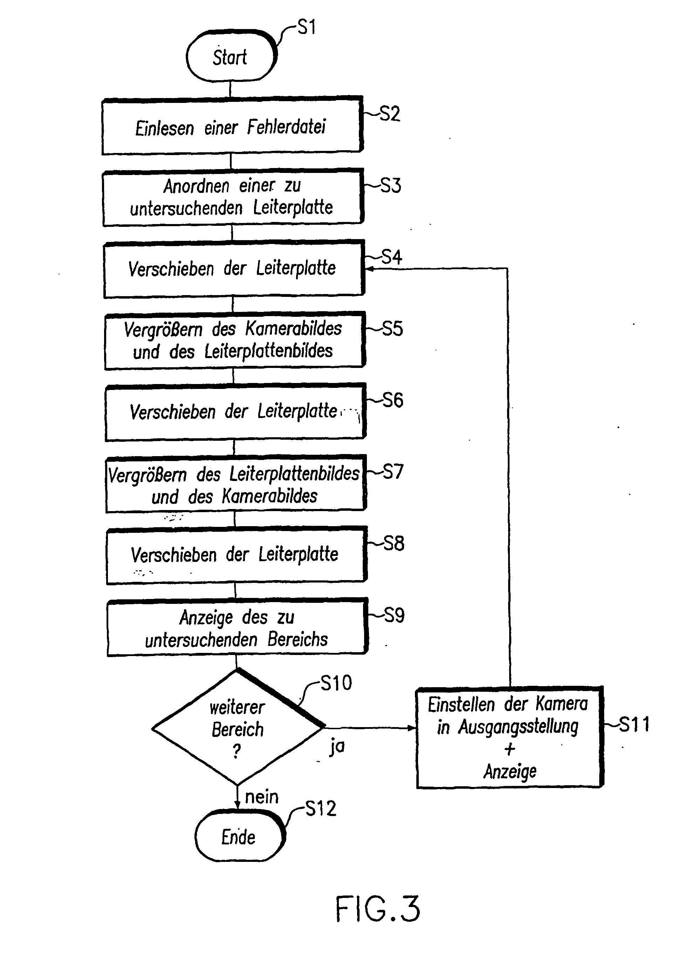

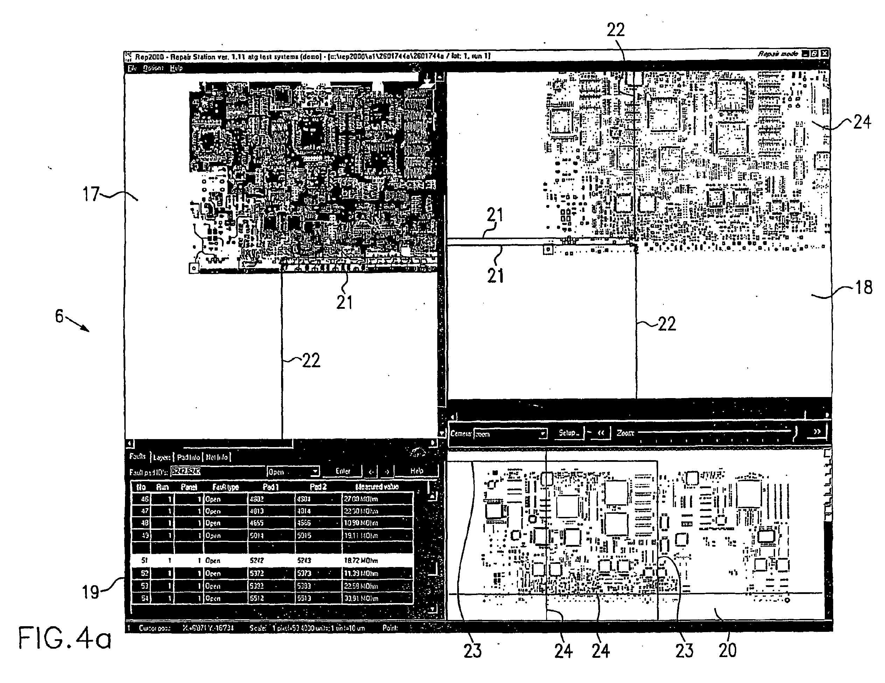

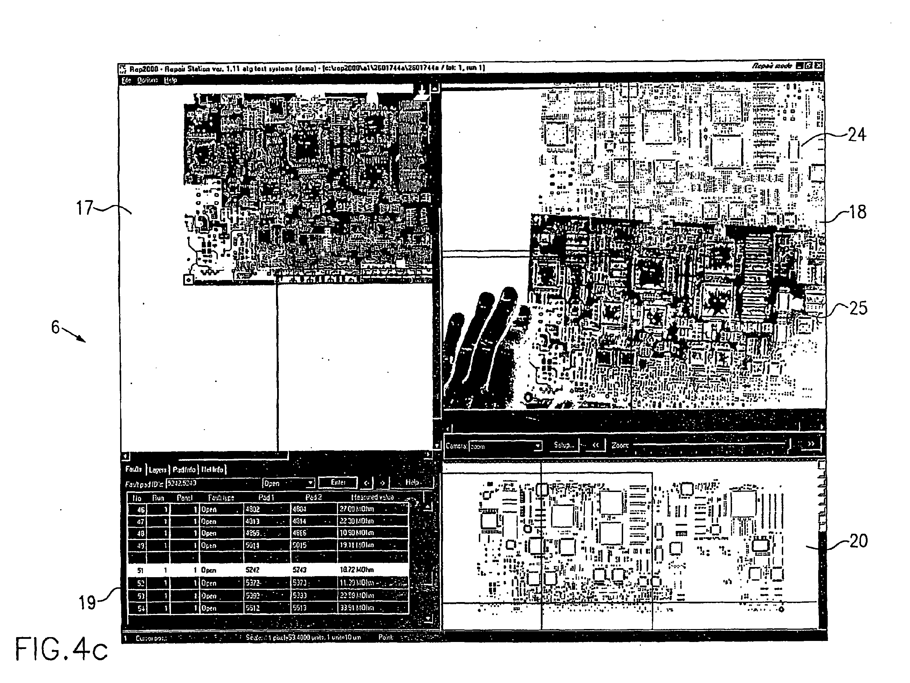

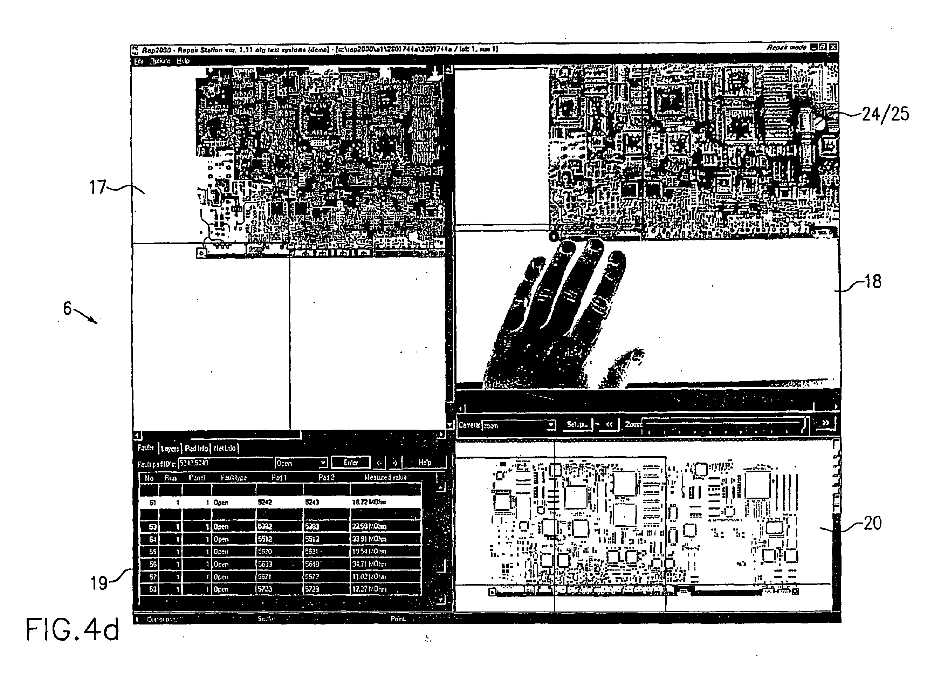

Das erfindungsgemäße Verfahren zum Untersuchen einer Leiterplatte an einem vorbestimmten Bereich der Leiterplatte wird nachfolgend näher anhand des in Fig. 3 gezeigten Flußdiagrammes und den in den Fig. 4a bis 4g gezeigten Bildschirmdarstellungen erläutert.

Das erfindungsgemäße Verfahren ist als Computerprogramm realisiert, das im Datenspeicher 15 des Computers 7 gespeichert ist. Nach dem Einschalten des Computers 7 und Initialisieren des Programms kann das Programm bzw. das erfindungsgemäße Verfahren durch betätigen des Fußtasters 9 gestartet werden (Schritt S1). Hierbei wird das Zoomobjektiv der Kamera 4 in eine Ausgangsstellung (Brennweite f₀=4,1 mm) eingestellt, so dass der Abtastbereich 12 der Kamera einen Bereich auf der Tischplatte 11 erfasst, der z.B. 400 mm x 300 mm groß ist. Ein solcher Abtastbereich ist größer als die meisten zu untersuchende Leiterplatten ist. Bei größeren Leiterplatten kann lediglich ein Ausschnitt erfasst werden.

Am Bildschirm 6 werden vier unabhängige Darstellungen in jeweils einem Ausschnitt bzw. Fenster 17 bis 20 dargestellt (Fig. 4a bis 4g). Im Fenster 17, das am Bildschirm 6 links oben dargestellt ist, wird ein aus CAD-Daten erzeugtes Abbild der zu untersuchenden Leiterplatte 1 dargestellt, in dem sowohl Leiterplattentestpunkte als auch einzelne Leiterbahnen dargestellt sind. Dieses CAD-Bild 26 beruht auf den für die Messungen in der Leiterplattentestvorrichtung 2 verwendeten Daten der Leiterplattentestpunkte und der Leiterbahnen und zeigt die zu untersuchende Leiterplatte in einer grundsätzlich fehlerfreien Ausführung.

Im Fenster 18, das rechts oben am Bildschirm dargestellt ist, wird ein Leiterplattenbild 24 gezeigt, das einen Teil der Leiterplattentestpunkte der zu untersuchenden Leiterplatte beinhaltet. Dieses Leiterplattenbild 24 enthält Informationen zur Leiterplatte, soweit sie zum Ausrichten eines Kamerabildes - das unten näher erläutert wird - einer zu untersuchenden Leiterplatte 1 bezüglich des Leiterplattenbildes notwendig sind. Es ist deshalb zweckmäßig, im Leiterplattenbild 24 nicht alle Leiterplattentestpunkte und Leiterbahnen darzustellen, denn diese Vielzahl von Informationen ist nicht zum Ausrichten des Kamerabildes notwendig und wird eher als störend wahrgenommen.

Im Schritt S2 wird eine Fehlerdatei von der Leiterplattentestvorrichtung 2 an die Prüfvorrichtung 3 übertragen, wobei die Fehler in einer Liste im Fenster 19 dargestellt werden.

Im Fenster 19, das am Bildschirm 6 links unten dargestellt ist, wird die Liste der vorab mit der Leiterplattentestvorrichtung 2 ermittelten Fehler gezeigt. Diese Liste ist in Form einer Tabelle dargestellt und weist mehrere Spalten auf, in welchen die Nummer des Fehlers (No), der Messdurchgang (Run), die Nummer der Leiterplatte (Panel), der Fehlertyp (Fault type), der erste Leiterplattentestpunkt (Pad1) und der zweite Leiterplattentestpunkt (Pad2) und der Messwert (Measured value) angegeben sind. Bei den Fehlertypen unterscheidet man in der Regel zwischen Unterbrechungen (o-pen) und Kurzschlüssen (short). Die Messungen sind in der Regel Zweipunkt-Messungen zwischen zwei Leiterplattentestpunkten, wobei der Widerstand der dazwischen angeordneten Leiterbahn gemessen wird. Der entsprechende Widerstandswert wird in der Tabelle als Messwert dargestellt. Wird in der Leiterplattentestvorrichtung 2 ein anderes Messverfahren verwendet, bei dem z.B. lediglich ein einziger Leiterplattentestpunkt kontaktiert wird, ist die Tabelle entsprechend abzuwandeln. Ein solches Verfahren ist bspw. aus der US 5,903,160 bekannt.

Beim Start des Programms werden im Fenster 17 und 18 das CAD-Bild 26 bzw. das Leiterplattenbild 24 derart angeordnet, dass sich der zu untersuchende Bereich der Leiterplatte 1 etwa mittig in dem jeweiligen Fenster 17, 18 befindet. Beim vorliegenden Ausführungsbeispiel wird der zu untersuchende Bereich durch einen Leiterplattentestpunkt vorgegeben, der mit einer Leiterbahn verbunden ist, die aufgrund der vorhergehenden Messung als fehlerhaft beurteilt worden ist.

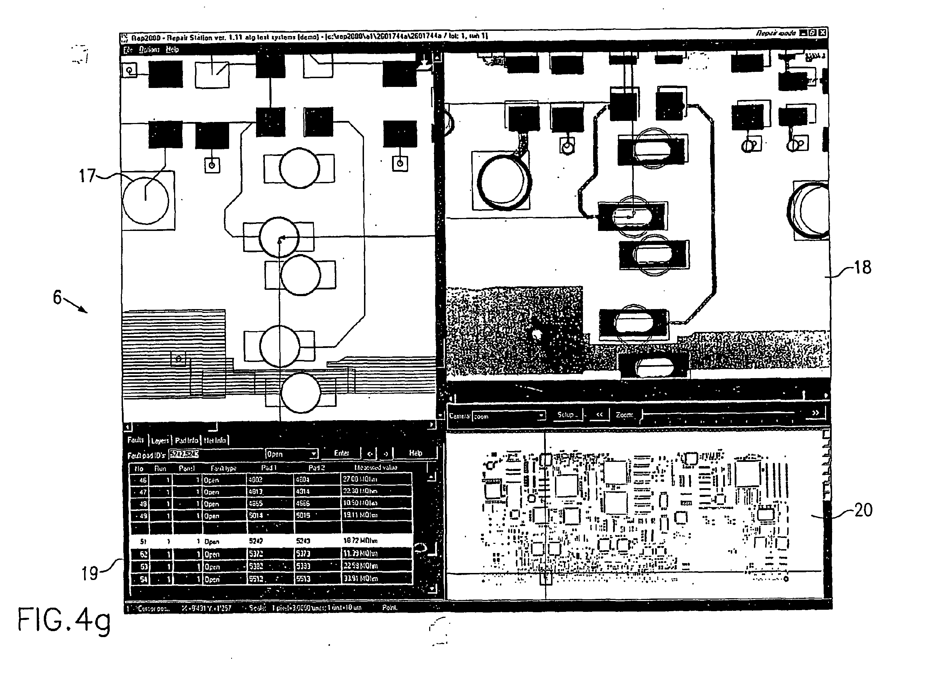

Diese Leiterplattentestpunkte werden jeweils durch einen horizontalen Pfeil 21 und einem vertikalen Pfeil 22 markiert. Bei dem in den Fig. 4a bis 4g gezeigten Ausführungsbeispiel werden beide mit der als fehlerhaft beurteilten Leiterbahn verbundenen Leiterplattentestpunkte mit entsprechenden Pfeilen 21, 22 markiert, wobei in den Fig. 4a bis 4f gezeigten Leiterplattenbilder 24 und CAD-Bilder 26 bzgl. des oberen Leiterplattentestpunktes mittig im jeweiligen Fenster 17, 18 ausgerichtet und in Fig. 4g mittig bzgl. des unteren Leiterplattentestpunktes ausgerichtet sind.

Im Fenster 19 wird der jeweils zu untersuchende Fehler in der Tabelle durch eine inverse Darstellung der entsprechenden Zeile hervorgehoben.

Im Fenster 20 wird die gesamte zu untersuchende Leiterplatte 1 in der Darstellung des Leiterplattenbildes aus dem Fenster 18 gezeigt und hierin ist mit einem Rahmen 23 der Ausschnitt der zu untersuchenden Leiterplatte eingezeichnet, der in den Fenstern 17 und 18 dargestellt wird. Zusätzlich ist ein Fadenkreuz 24 eingezeichnet, dessen Kreuzungspunkt den zu untersuchenden Leiterplattentestpunkt markiert.

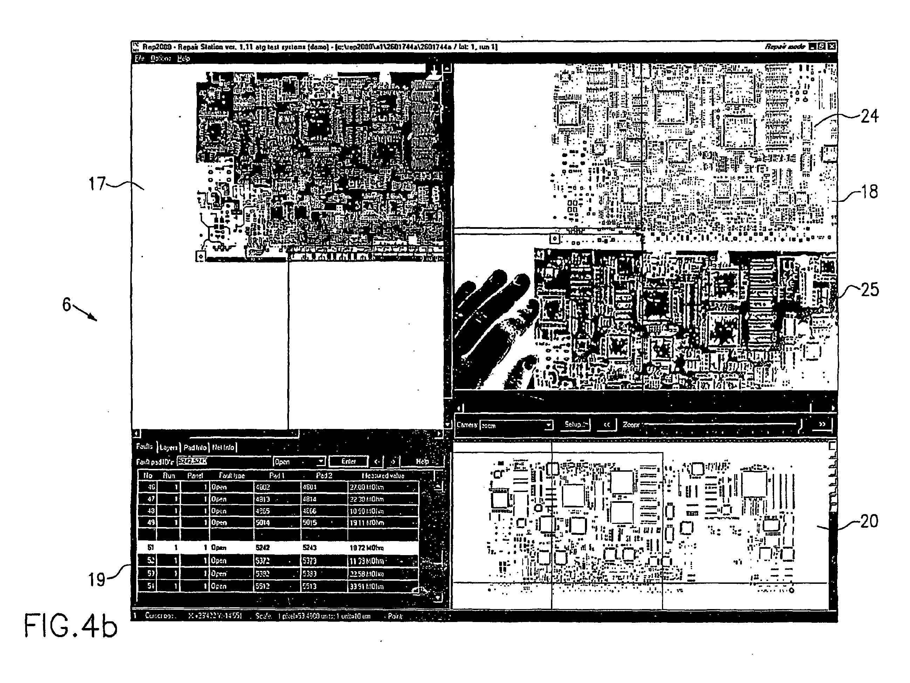

Im Schritt S3 wird die zu untersuchende Leiterplatte 1 im Abtastbereich 12 der Kamera 4 auf der Tischplatte 11 angeordnet (Fig. 4b). Die Kamera 4 erfasst die Leiterplatte und erzeugt ein digitales Kamerabild 25 der zu untersuchenden Leiterplatte. Dieses Kamerabild 25 wird im Fenster 18 dargestellt.

Die Leiterplatte wird nun verschoben, bis das Kamerabild 25 und das Leiterplattenbild 24 im Fenster 18 in Deckung gebracht sind (Schritt S4). Hierdurch wird die Leiterplatte 1 bzgl. des Leiterplattenbildes 24 ausgerichtet.

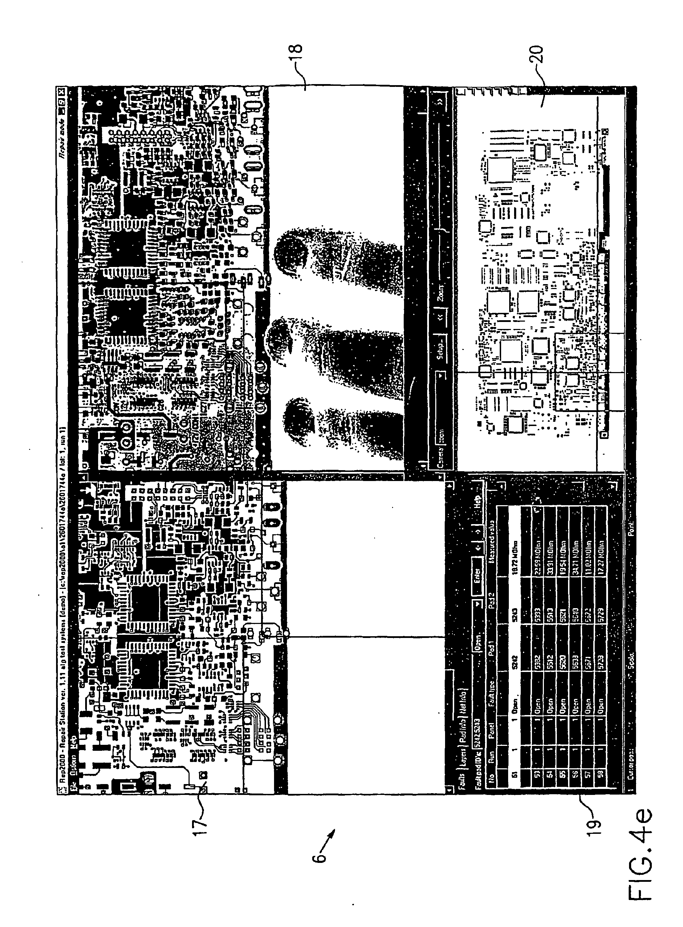

Durch erneutes Betätigen des Fußtasters 9 werden das Kamerabild 25 und das Leiterplattenbild 24 im selben Verhältnis vergrößert (Schritt S5). Durch die vergrößerte Darstellung kann der Bediener der Prüfvorrichtung die bestehenden Abweichungen zwischen dem Kamerabild 25 und dem Leiterplattenbild 24 gut erkennen. Die Leiterplatte 1 wird deshalb erneut verschoben (Schritt S5), um das Kamerabild 25 bzgl. des Leiterplattenbildes exakter in Deckung zu bringen (Fig. 4e).

Das Kamerabild 25 und das Leiterplattenbild 24 werden im Schritt S7 erneut im gleichen Verhältnis vergrößert und die Leiterplatte 1 wird im Schritt S8 wiederum verschoben, um eine noch exaktere Deckung zwischen dem Kamerabild 25 und dem Leiterplattenbild 24 zu erzielen.

Grundsätzlich wäre es auch möglich, die beiden Vergrößerungen des Kamerabildes und des Leiterplattenbildes aus den Schritten S5 und S7 in einem einzigen Schritt durchzuführen. Es hat sich jedoch in der Praxis gezeigt, dass eine Vergrößerung um einen Faktor von mehr als 20 nicht zweckmäßig ist, da die Abweichungen nach dem ersten Ausrichten im Schritt S4 zwischen dem Kamerabild 25 und dem Leiterplattenbild 24 noch so groß sind, dass bei einer derartigen Vergrößerung, bei der nur noch ein kleiner Ausschnitt von der Leiterplatte sichtbar ist, ein erneutes Ausrichten oftmals schwierig ist, insbesondere wenn die Leiterplatte im dargestellten Bereich ein sehr gleichmäßiges und regelmäßiges Raster von Leiterplattentestpunkten besitzt.

Nachdem das Leiterplattenbild 24 und das Kamerabild 25 in der maximal gewünschten Vergrößerung im Fenster 18 dargestellt sind, muss der zu untersuchende Bereich markiert werden (Schritt S9). Diese Markierung erfolgt durch den horizontalen Pfeil 21 und den vertikalen Pfeil 22, die auf die dem Leiterplattentestpunkt gerichtet sind. Beim vorliegenden Ausführungsbeispiel werden diese Pfeile vom Anfang des Verfahrens (Schritt S1) dargestellt. Im Rahmen der Erfindung ist es selbstverständlich aus möglich, diese Pfeile oder andere entsprechende Markierungen erst nach Durchführung der maximal gewünschten Vergrößerung anzuzeigen.

Der Lichtzeiger 27 ist derart eingestellt, dass er mit seinem Lichtstrahl 28 die Stelle auf der Leiterplatte 1 markiert, die dem zu untersuchenden Bereich entspricht. Da dieser Bereich immer mittig bzgl. des Fensters 17 ausgerichtet ist, befindet sich der durch den Lichtstrahl zu markierende Ort immer auf der gleichen Stelle der Arbeitsfläche, die im vorliegendem Ausführungsbeispiel durch die Tischplatte 11 dargestellt wird. Der Lichtzeiger muss deshalb lediglich einmal eingestellt werden und verbleibt während dem Durchführen des erfindungsgemäßen Verfahren stationär.

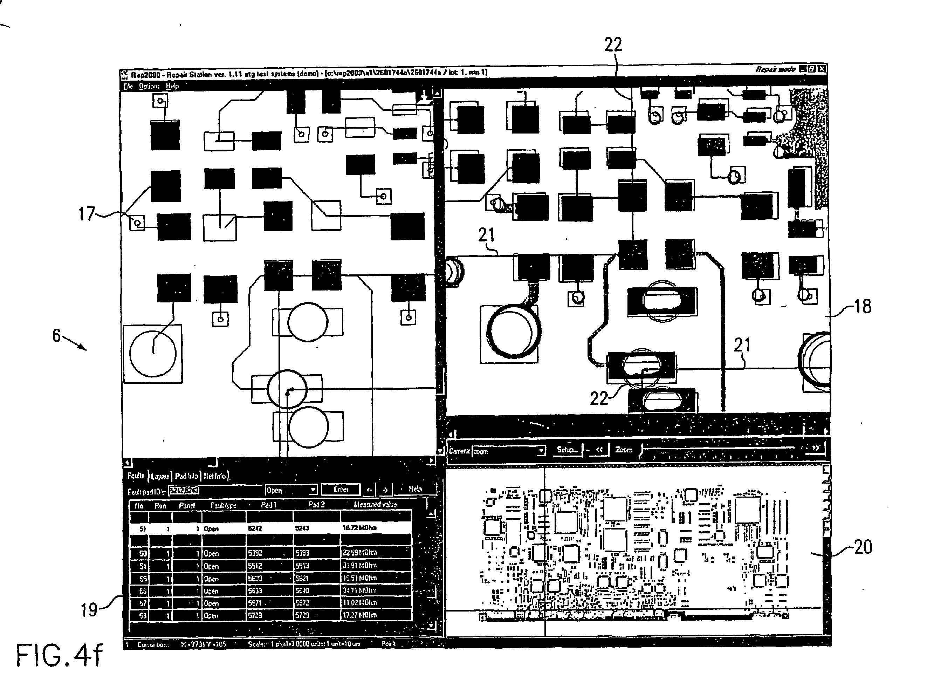

Hat der Anwender des erfindungsgemäßen Verfahrens den zu untersuchenden Leiterplattentestpunkt und die damit verbundene Leiterbahn ausreichend betrachtet (Fig. 4f), so betätigt er den Fußschalter, wodurch der Programmablauf auf den Schritt S10. übergeht. Hierin wird abgefragt, ob in der im Fenster 19 dargestellten Liste noch ein weiterer zu untersuchender Leiterplattentestpunkt enthalten ist. Ergibt die Abfrage, dass noch ein weiterer zu untersuchender Leiterplattentestpunkt vorhanden ist, geht der Programmablauf auf den Schritt S11 über, bei dem die Kamera wieder in der Ausgangsstellung (Brennweite f₀) eingestellt wird und das Leiterplattenbild 24 im Fenster 18 im entsprechenden Maßstab mit dem weiteren zu untersuchenden Leiterplattentestpunkt in der Mitte des Fensters 18 angezeigt wird.

Danach geht der Programmablauf zurück auf den Schritt S4, womit sich das Verfahren zum Ausrichten der zu untersuchenden Leiterplatte bzgl. des Leiterplattenbildes gemäß den Schritten S4 bis S8 wiederholen. Im Schritt S9 wird wiederum der zu untersuchende Punkt bzw. Bereich angezeigt (Fig. 4g).

Ergibt die Abfrage im Schritt S10 hingegen, dass in der Liste kein weiterer zu untersuchender Punkt vorhanden ist, geht der Programmablauf auf den Schritt S12 über, mit dem das Programm beendet wird.

Bei dem oben erläuterten Verfahren wird das CAD-Bild 26 im Fenster 17 jeweils im gleichen Maßstab und mit dem entsprechenden Ausschnitt wie das Leiterplattenbild 24 im Fenster 18 dargestellt. Das CAD-Bild 26 enthält die Daten, die der Leiterplattentestvorrichtung 2 zum Testen der Leiterplatte zur Verfügung stehen. Bei dem in den Fig. 4f und 4g gezeigten Beispiel zeigt das CAD-Bild 26 einen Leiterplattentestpunkt in Form.eines Kreises. Die tatsächliche, korrekte Ausführungsform des Leiterplattentestpunktes ist jedoch ein langgezogenes Rechteck mit einer ovalen Ausnehmung, wie es anhand des Kamerabildes im Fenster 18 erkennbar ist (Fig. 4f und 4g). Derartige Abweichungen der den Messungen zugrundeliegenden CAD-Daten gegenüber der tatsächlichen Ausführungsform entstehen bei der Aufbereitung der ursprünglichen CAD-Daten in CAD-Testdaten, da hierbei das Format der Daten verändert wird. Der Anwender stellt anhand der vergrößerten Darstellung gemäß Fig. 4f und 4g fest, dass die elektrische Verbindung zwischen den zu untersuchenden Leiterplattentestpunkten in Ordnung ist und dass der Messfehler auf nicht mit der tatsächlichen Ausführungsform übereinstimmenden Daten beruht. Die Verbindung wird somit als korrekt beurteilt, womit der Verfahrensablauf auf den nächsten in der Liste enthaltenden Leiterplattentestpunkt des nächsten Fehlers übergehen kann.

In der in den Fig. 4f und 4g stark vergrößerten Ansicht der Leiterplatte können jedoch auch Unterbrechungen und Kurzschlüsse optisch erkannt werden. Wird ein derartiger Fehler erkannt, wird er entweder sofort beseitigt oder falls dies nicht möglich ist, entsprechend markiert. Er kann dann einer weiteren Nachbearbeitung unterzogen werden, wenn der Fehler behebbar ist, ansonsten ist die zu untersuchende Leiterplatte Ausschuss.

Bei dem oben erläuterten Beispiel sind die beiden Leiterplattentestpunkte der zu untersuchenden Leiterbahn so nahe beieinander angeordnet, dass beide in der maximal vergrößerten Darstellung (Fig. 4f und 4g) gleichzeitig in den Fenstern 17 oder 18 angezeigt werden. Die Leiterbahnen sind jedoch oftmals länger, so dass es nicht möglich ist, beide Endpunkte der Leiterbahnen, die entsprechenden Leiterplattentestpunkte, gleichzeitig in den Fenstern 17 und 18 darzustellen. Wird das oben erläuterte Verfahren ausgeführt, so wird in einem Verfahrensdurchgang der eine Leiterplattentestpunkt und im anderen Verfahrensdurchgang der andere Leiterplattentestpunkt angezeigt, wobei bei langen Leiterbahnen ein dazwischen liegender Verbindungsabschnitt der Leiterbahnen nicht in der maximal vergrößerten Darstellung angezeigt werden kann. Nach einer bevorzugten Ausführungsform des erfindungsgemäßen Verfahrens wird bei derart langen Leiterbahnen nach dem Betrachten des ersten mit dieser Leiterbahn verbundenen Leiterplattentestpunktes im nächsten Programmdurchlauf mit den Schritten S4 bis S9 nicht der andere mit dieser Leiterbahn verbundene Leiterplattentestpunkt sondern ein Abschnitt der entsprechenden Leiterbahn dargestellt. Mit jedem weiteren Programmdurchlauf werden weitere, benachbarte Abschnitte der zu untersuchenden Leiterbahn vergrößert, bis die gesamte Leiterbahn abschnittsweise vergrößert aufeinanderfolgend vollständig dargestellt worden ist. Am Ende der Untersuchung einer Leiterbahn wird der bisher noch nicht betrachtete, mit dieser Leiterbahn verbundene Leiterplattetestpunkt vergrößert dargestellt. Bei dieser bevorzugten Abwandlung des erfindungsgemäßen Verfahrens werden somit längere Leiterbahnen, die bei vergrößerter Darstellung nicht vollständig im Fenster 18 angezeigt werden können, abschnittsweise in aufeinanderfolgenden benachbarten Abschnitten dargestellt. Vorzugsweise überlappen sich die Abschnitte teilweise.

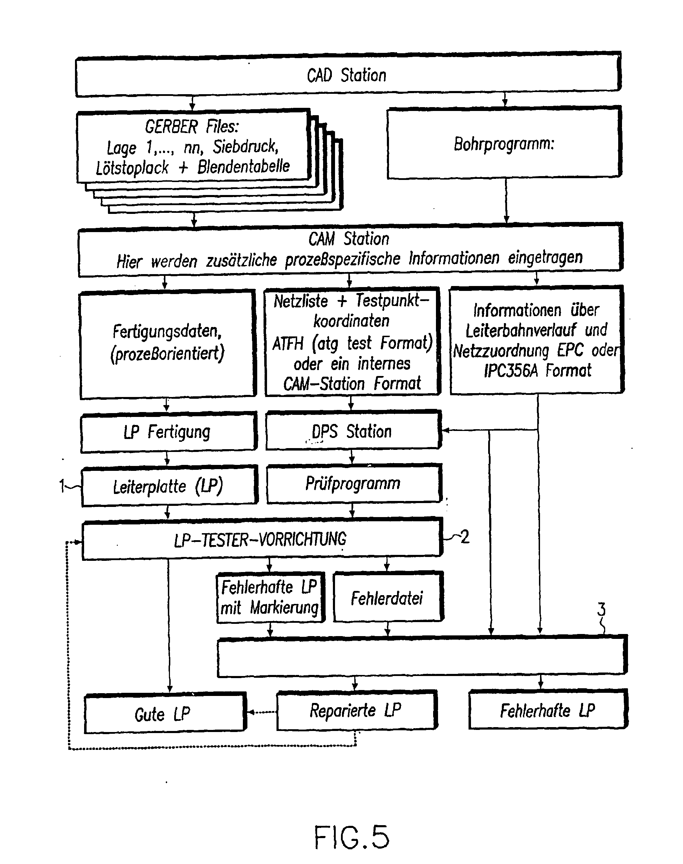

Fig. 5 zeigt den Ablauf der Herstellung von Leiterplatten. Zunächst wird eine Leiterplatte an einer CAD-Station entworfen. Aus den ursprünglichen CAD-Daten werden sogenannte GERBER-Files berechnet, die für jede Lage Siebdruck- und Lötstoplack-Informationen sowie Blendentabellen beinhalten. Parallel hierzu wird ein Bohrprogramm für die in die Leiterplatte einzubringenden Durchkontaktierungen erstellt. Die GERBER-Daten und das Bohrprogramm werden in eine CAM-Station eingegeben, wobei zusätzliche prozessspezifische Informationen eingetragen werden. Aus den CAM-Daten werden Fertigungsdaten für die Fertigung der Leiterplatten, Netzlisten und Testpunktkoordinaten und Informationen über den Leiterbahnverlauf und die Netzzuordnung abgeleitet. Die Netzlisten und Testpunktkoordinaten sind im ATFH-Format (Atg-Test-Format). Die Informationen über den Leiterbahnverlauf und die Netzzuordnungen sind im EPC-Format oder IPC 356A-Format.

Die Fertigungsdaten werden an die Leiterplattenfertigung und die Netzlisten und Testpunktkoordinaten sowie die Informationen über den Leiterbahnverlauf werden an eine DPS-Station weitergeleitet. Bei der Leiterplatten-Fertigung werden Leiterplatten LP hergestellt und in der DPS-Station wird ein Prüfprogramm generiert. Das Prüfprogramm wird auf die Leiterplattentestvorrichtung 2 überspielt, so dass mit dieser die hergestellten Leiterplatten 1 getestet werden. Ergibt der Test der Leiterplatte, dass sie fehlerfrei ist, wird sie einem Stapel mit guten Leiterplatten zugeordnet. Ergibt der Test hingegen, dass die Leiterplatte einen Fehler aufweist, so wird die Leiterplatte als fehlerhaft markiert. Parallel wird eine Fehlerdatei angelegt. Die Fehlerdatei wird zur Prüfvorrichtung 3 übertragen, so dass mit der Prüfvorrichtung 3 die fehlerhafte Leiterplatte in der oben erläuterten Weise untersucht werden kann. Hierzu werden auch das Prüfprogramm der Leiterplattentestvorrichtung, das alleine Informationen zu den Leiterplattentestpunkten beinhaltet, und die Informationen über den Leiterbahnverlauf und Netzzuordnungen auf die Prüfvorrichtung übertragen, mit welchen das CAD-Bild 26 des Fensters 17 bzw. die Leiterplattenbilder 24 der Fenster 18, 20 erzeugt werden.

Die mit dem erfindungsgemäßen Verfahren untersuchten fehlerhaften Leiterplatten werden entweder repariert und dann dem Stapel der guten Leiterplatten zugeführt oder falls eine Reparatur nicht möglich ist, werden diese Leiterplatten dem Ausschuss zugeführt.

Das oben erläuterte Ausführungsbeispiel dient somit zum Überprüfen einzelner Leiterplatten, die mit einer Leiterplattentestvorrichtung getestet worden sind. Im Rahmen der Erfindung ist es jedoch auch möglich, das Verfahren zum Korrigieren des Prüfprogramms zu verwenden. Werden bei der Durchführung des erfindungsgemäßen Verfahrens Abweichungen zwischen dem CAD-Bild 26 und dem tatsächlich korrekt ausgeführten Leiterbahnen und Leiterplattentestpunkten gemäß dem Kamerabild 25 erkannt, so können diese Differenzen bei einer Weiterbildung des erfindungsgemäßen Verfahrens über die Tastatur 8 eingegeben und abgespeichert werden. Sind alle Abweichungen zu einem Leiterplattentyp erfasst, so werden die entsprechenden Daten von der Prüfvorrichtung 3 an die DPS-Station übertragen, an der ein überarbeitetes Prüfprogramm erzeugt wird. Das erfindungsgemäße Verfahren kann somit auch zum Korrigieren von Prüfprogrammen eingesetzt werden.

Die Erfindung ist oben anhand eines Ausführungsbeispieles näher erläutert worden. Die Erfindung ist jedoch nicht auf dieses konkrete Ausführungsbeispiel beschränkt. Im Rahmen der Erfindung ist es möglich, z.B. anstelle einer Kamera mit einem Zoomobjektiv eine hochauflösende Kamera mit einem Objektiv mit fester Brennweite zu verwenden. Das Zoomen bzw. Vergrößern der am Bildschirm dargestellten Bilder erfolgt dann rechnerisch im Computer durch Auswählen entsprechender Ausschnitte des von der Kamera erfassten Bildes. Anstelle eines Fußtasters kann auch eine beliebige andere Taste verwendet werden, wobei ein Fußtaster jedoch vorteilhaft ist, da die Hände des Bedieners frei zum Verschieben der Leiterplatte sind. Am oben beschriebenen Ausführungsbeispiel sind die vorbestimmten Bereiche jeweils durch einzelne Leiterplattentestpunkte festgelegt. Es ist jedoch auch möglich, die Bereiche unabhängig von den Testpunkten zu definieren, insbesondere als flächige Elemente anstelle von Punkten.

Wesentliche Vorteile des erfindungsgemäßen Verfahrens sind die sehr einfache Handhabung, schnelle Auffindung der vorbestimmten Bereiche und dass lediglich handelsübliche Hardware benötigt wird, die ohne aufwendige mechanische oder elektrische Aufbauten zusammengefügt werden kann. Das erfindungsgemäße Verfahren lässt sich somit sehr kostengünstig realisieren und erlaubt einen hohen Durchsatz an zu untersuchenden Leiterplatten.

Das oben beschriebene Ausführungsbeispiel ist zur Untersuchung von unbestückten Leiterplatten vorgesehen. Grundsätzlich ist es jedoch auch möglich, dieses Verfahren zum Untersuchen von bestückten Leiterplatten und insbesondere als Hilfsmittel zum Bestücken von Leiterplatten zu verwenden. Anstelle von Leiterplattentestpunkten können dann entsprechende Komponenten am Bildschirm oder mittels eines Lichtzeigers angezeigt werden.

Im Rahmen dieser Erfindung ist es auch möglich, eine Sprachsteuerung vorzusehen, so dass der Fußtaster entfallen kann.

Das erfindungsgemäße Verfahren kann auch dahingehend abgewandelt werden, dass die Leiterplatte lediglich ein einziges Mal durch Verschieben ausgerichtet wird und das Kamerabild mittels eines Verfahrens zur automatischen Bilderkennung analysiert wird, so dass die einzelnen mit der Kamera erfassten Elemente (Leiterplattentestpunkte, Leiterbahnen) bestimmt sind. Das Kamerabild wird dann automatisch mit dem Leiterplattenbild in Deckung gebracht werden, da die zueinander in Deckung zu bringenden Leiterplattentestpunkte des Kamerabildes und des Leiterplattenbildes einander zuordbar sind.

### Bezugszeichenliste

- 1: Leiterplatte
- 2: Leiterplattentestvorrichtung
- 3: Prüfvorrichtung
- 4: Kamera
- 5: Haltestange
- 6: Bildschirm
- 7: Computer
- 8: Tastatur
- 9: Fußtaster
- 10: Tisch
- 11: Tischplatte
- 12: Abtastbereich
- 13: Datenbus
- 14: CPU-Einheit
- 15: Datenspeicher
- 16: Interfaceeinrichtung
- 17: Fenster
- 18: Fenster
- 19: Fenster
- 20: Fenster
- 21: horizontaler Pfeil
- 22: vertikaler Pfeil
- 23: Rahmen
- 24: Leiterplattenbild
- 25: Kamerabild
- 26: CAD-Bild
- 27: Lichtzeiger
- 28: Lichtstrahl

## Patentansprüche

1. Verfahren zum Untersuchen einer Leiterplatte an einem vorbestimmten Bereich der Leiterplatte (1) mit einer Vorrichtung, die eine stationär angeordnete Kamera (4) und eine Anzeigeeinrichtung (6) aufweist, umfassend folgende Schritte:
a) Anordnen einer zu untersuchenden Leiterplatte (1) im Abtastbereich (12) der Kamera (4), wobei ein Kamerabild (25) und ein vom Kamerabild (25) unabhängiges Leiterplattenbild (24) auf der Anzeigeeinrichtung (6) im gleichen Maßstab dargestellt werden,
b) Verschieben der zu untersuchenden Leiterplatte (1), um das Kamerabild (25) möglichst weitgehend mit dem Leiterplattenbild (24) in Deckung zu bringen,
c) Vergrößern des Kamerabildes und des Leiterplattenbildes im gleichen Verhältnis auf der Anzeigeeinrichtung (6),
d) in exaktere Deckung Bringen des Kamerabildes (25) bzgl. des Leiterplattenbildes, und
e) Anzeigen des zu untersuchenden vorbestimmten Bereichs, so dass der vorbestimmte Bereich der zu untersuchenden Leiterplatte (1) in vergrößerter Darstellung an der Anzeigeeinrichtung (6) erkennbar ist.

2. Verfahren nach Anspruch 1,
**dadurch gekennzeichnet,**
**dass** das in exaktere Deckung Bringen des Kamerabildes (25) bzgl. des Leiterplattenbildes (24) durch Verschieben der Leiterplatte (1) erfolgt.

3. Verfahren nach Anspruch 1,
**dadurch gekennzeichnet,**
**dass** das in exaktere Deckung Bringen des Kamerabildes (25) bzgl. des Leiterplattenbildes (24) mittels eines automatischen Bilderkennungsverfahrens erfolgt, das das Kamerabild (25) analysiert und mit dem Leiterplattenbild (24) automatisch in Deckung bringt.

4. Verfahren nach einem der Ansprüche 1 bis 3,
**dadurch gekennzeichnet,**
**dass** das Leiterplattenbild (24) in einem vorbestimmten Ausschnitt der Anzeigeeinrichtung (18) derart dargestellt wird, dass der zu untersuchende vorbestimmte Bereich etwa mittig in dem Ausschnitt (18) der Anzeigeeinrichtung (6) angeordnet ist.

5. Verfahren nach einem der Ansprüche 1 bis 4,
**dadurch gekennzeichnet,**
**dass** der zu untersuchende vorbestimmte Bereich einem Fehler der Leiterplatte entspricht, der vorab mit einer Leiterplattentestvorrichtung (2) festgestellt worden ist.

6. Verfahren nach Anspruch 5,
**dadurch gekennzeichnet,**
**dass** der zu untersuchende vorbestimmte Bereich im Leiterplattenbild (24) durch jeweils einen Leiterplattentestpunkt festgelegt ist, der mit einer Leiterbahn der Leiterplatte verbunden ist, die durch die vorab an der Leiterplattentestvorrichtung (2) durchgeführten Messungen als fehlerhaft beurteilt wurde, und durch einen Pfeil (21, 22) angezeigt wird, dessen Spitzen an dem Leiterplattentestpunkt enden.

7. Verfahren nach Anspruch 5,
**dadurch gekennzeichnet,**
**dass** der zu untersuchende Bereich jeweils einem an der Anzeigeeinrichtung darstellbaren Abschnitt einer als fehlerhaft beurteilten Leiterbahn entspricht, wobei mehrer benachbarte Abschnitte der Leiterbahn aufeinanderfolgend durch Wiederholen der Schritte a) bis e) vergrößert auf der Anzeigeeinrichtung zur Darstellung gebracht werden.

8. Verfahren nach einem der Ansprüche 5 bis 7,
**dadurch gekennzeichnet,**
**dass** nach den in der Leiterplattentestvorrichtung durchgeführten Messungen eine Fehlerdatei erzeugt wird, die eine Liste aller gemessenen Fehler aufweist, und dass durch Betätigen einer einzigen Taste die Schritte a) und c) wiederholt aufrufbar sind, so dass alle zu untersuchenden Bereiche alleine durch Verschieben der Leiterplatte (1) und Betätigen der Taste (9) in vergrößerter Darstellung an der Anzeigeeinrichtung zur Anzeige gebracht werden.

9. Verfahren nach Anspruch 8,
**dadurch gekennzeichnet,**
**dass** als Taste ein Fußtaster (9) verwendet wird.

10. Verfahren nach einem der Ansprüche 1 bis 9,
**dadurch gekennzeichnet,**
**dass** der Schritt c) des Vergrößerns des Kamerabildes und des Leiterplattenbildes und des Verschiebens der zu untersuchenden Leiterplatte für jeden zu untersuchenden Bereich zweimal oder dreimal wiederholt wird, wobei der Vergrößerungsfaktor pro Vergrößerung des Kamerabildes und des Leiterplattenbildes nicht größer als 20 ist.

11. Verfahren nach einem der Ansprüche 1 bis 10,
**dadurch gekennzeichnet,**
**dass** an der Anzeigeeinrichtung (6) zwei Ausschnitte (17, 18) vorgesehen sind, wobei in einem Ausschnitt (18) das Leiterplattenbild (24) und das Kamerabild (25) angezeigt werden und im anderen Ausschnitt (17) ein Bild (26) der Leiterplatte im gleichen Maßstab wie das Leiterplattenbild (24) und das Kamerabild (25) gezeigt wird, in dem sowohl Leiterplattentestpunkte als auch Leiterbahnen dargestellt sind.

12. Verfahren nach einem der Ansprüche 1 bis 11,
**dadurch gekennzeichnet,**
**dass** eine Vorrichtung verwendet wird, mit
- einer stationären Kamera (4),
- einer Anzeigeeinrichtung (6), die mit der Kamera (4) verbunden ist, um ein Leiterplattenbild (24) und ein von der Kamera erfasstes Kamerabild (25) einer zu untersuchenden Leiterplatte (1) im gleichen Maßstab anzuzeigen,
- eine Einrichtung zum Vergrößern des Kamerabildes und des Leiterplattenbildes im gleichen Verhältnis auf der Anzeigeeinrichtung (6).

13. Verfahren nach Anspruch 12,
**dadurch gekennzeichnet**
**dass** die Vorrichtung einen Computer (7) mit einer zentralen Recheneinheit (14), einem Daten- und Programmspeicher (15) und einem Bildschirm (6), der die Anzeigeeinrichtung darstellt, aufweist.

14. Verfahren nach Anspruch 12 oder 13,
**dadurch gekennzeichnet,**
**dass** die Vorrichtung mit einer Leiterplattentestvorrichtung (2) über eine Datenleitung zum Übertragen einer Fehlerdatei verbunden ist.

15. Verfahren nach einem der Ansprüche 12 bis 14,
**dadurch gekennzeichnet,**
**dass** die Kamera ein Zoom-Objektiv aufweist, dessen Brennweite elektrisch ansteuerbar ist.

16. Verfahren nach einem der Ansprüche 12 bis 15,
**dadurch gekennzeichnet,**
**dass** die Kamera ein Fokussiereinrichtung aufweist.

17. Vorrichtung zum Durchführen eines Verfahrens nach einem der Ansprüche 1 bis 11, mit
- einer stationären Kamera (4),
- einer Anzeigeeinrichtung (6), die mit der Kamera (4) verbunden ist, um ein Leiterplattenbild (24) und ein von der Kamera erfasstes Kamerabild (25) einer zu untersuchenden Leiterplatte (1) im gleichen Maßstab anzuzeigen,
- eine Einrichtung zum Vergrößern des Kamerabildes und des Leiterplattenbildes im gleichen Verhältnis auf der Anzeigeeinrichtung (6),
wobei die Vorrichtung mit einer Leiterplattentestvorrichtung (2) über eine Datenleitung zum Übertragen einer Fehlerdatei verbunden ist.

18. Vorrichtung nach Anspruch 17,
**gekennzeichnet durch**
einen Computer (7) mit einer zentralen Recheneinheit (14), einem Daten- und Programmspeicher (15) und einem Bildschirm (6), der die Anzeigeeinrichtung darstellt.

19. Vorrichtung nach Anspruch 17 oder 18,
**dadurch gekennzeichnet,**
**dass** die Kamera ein Zoom-Objektiv aufweist, dessen Brennweite elektrisch ansteuerbar ist.

20. Vorrichtung nach einem der Ansprüche 17 bis 19,
**dadurch gekennzeichnet,**
**dass** die Kamera ein Fokussiereinrichtung aufweist.

## Claims

1. Method of examining a circuit board in a predetermined area of the circuit board (1) using an apparatus which has a stationary camera (4) and a display unit (6), comprising the following steps:
a) positioning of a circuit board (1) to be examined in the scanning zone (12) of the camera (4), wherein a camera image (25) and a circuit board image (24) separate from the camera image (25) are shown on the display unit (6) on the same scale,
b) movement of the circuit board (1) to be examined, to make the camera image (25) as congruent as possible with the circuit board image (24),
c) enlargement of the camera image and the circuit board image on the display unit (6) in the same ratio,
d) bringing the camera image (25) to coincide more closely with the circuit board image, and
e) display of the predetermined area to be examined, so that an enlarged view of the predetermined area of the circuit board (1) to be examined is visible on the display unit (6).

2. Method according to claim 1,
**characterized in that**
the camera image (25) and the circuit board image (24) are brought into closer alignment by moving the circuit board (1).

3. Method according to claim 1,
**characterized in that**
the bringing into closer alignment of the camera image (25) and the circuit board image (24) is effected by means of an automatic image recognition method, which analyses the camera image (25) and brings it automatically into congruence with the circuit board image (24).

4. Method according to any of claims 1 to 3,
**characterized in that**
the circuit board image (24) is displayed in a predetermined section (18) of the display unit (6) in such a way that the predetermined area to be examined is approximately in the centre of the section (18) of the display unit (6).

5. Method according to any of claims 1 to 4,
**characterized in that**
the predetermined area to be examined corresponds to a defect in the circuit board which has been detected beforehand by a circuit board tester (2).

6. Method according to claim 5,
**characterized in that**
each predetermined area to be examined is defined in the circuit board image (24) by a circuit board test point linked to a track on the circuit board which has been judged to be defective by the measurements made in advance on the circuit board tester (2), and indicated by arrows (21, 22), the tips of which end at the circuit board test point.

7. Method according to claim 5,
**characterized in that**
each area to be examined corresponds to a section of a track, judged as defective and able to be shown on the display unit, wherein several adjacent sections of the track may be shown consecutively on the display unit in an enlarged view by repeating steps a) to e).

8. Method according to any of claims 5 to 7,
**characterized in that**,
following the measurements made in the circuit board tester a defect file is generated, containing a list of all measured defects, and that by actuating a single key steps a) and c) may be repeated, so that all areas to be examined may be shown on the display unit in an enlarged view solely by moving the circuit board (1) and actuating the key (9).

9. Method according to claim 8,
**characterized in that**
a control pedal (9) is used as key.

10. Method according to any of claims 1 to 9,
**characterized in that**
step c), involving enlargement of the camera image and the circuit board image and movement of the circuit board to be examined, is repeated two or three times for each area to be examined, wherein the enlargement factor for each enlargement of the camera image and the circuit board image does not exceed 20.

11. Method according to any of claims 1 to 10,
**characterized in that**
the display unit (6) is provided with two sections (17, 18), wherein the circuit board image (24) and the camera image (25) are displayed in one section (18), while the other section (17) displays an image (26) of the circuit board on the same scale as the circuit board image (24) and the camera image (25), and showing both circuit board test points and tracks.

12. Method according to any of claims 1 to 11, **characterized in that** an apparatus is used, having
- a stationary camera (4),
- a display unit (6) linked to the camera (4), for displaying on the same scale a circuit board image (24) and a camera image (25) of a circuit board to be examined, as recorded by the camera,
- a device to enlarge the camera image and the circuit board image on the display unit (6) in the same ratio.

13. Method according to claim 12,
**characterized by** an apparatus, having
a computer (7) with a central processor unit (14), a data and program memory (15) and a video screen (6) representing the display unit.

14. Method according to claim 12 or 13,
**characterized in that**
the apparatus is linked to a circuit board tester (2) via a data line for the transmission of a defect file.

15. Method according to any of claims 12 to 14,
**characterized in that**
the camera has a zoom lens, with a focal length which may be selected electrically.

16. Method according to any of claims 12 to 15,
**characterized in that**
the camera has a focussing device.

17. Apparatus for implementing a method according to any of claims 1 to 11, having
- a stationary camera (4),
- a display unit (6) linked to the camera (4), for displaying on the same scale a circuit board image (24) and a camera image (25) of a circuit board to be examined, as recorded by the camera,
- a device to enlarge the camera image and the circuit board image on the display unit (6) in the same ratio,
wherein the apparatus is linked to a circuit board tester (2) via a data line for the transmission of a defect file.

18. Apparatus according to claim 17,
**characterized by**
a computer (7) with a central processor unit (14), a data and program memory (15) and a video screen (6) representing the display unit.

19. Apparatus according to claim 17 or 18,
**characterized in that**
the camera has a zoom lens, with a focal length which may be selected electrically.

20. Apparatus according to any of claims 17 to 19,
**characterized in that**
the camera has a focussing device.

## Revendications

1. Procédé pour analyser une carte à circuits imprimés dans une zone prédéterminée de la carte à circuits imprimés (1), au moyen d'un dispositif qui comprend une caméra (4) agencée stationnaire et un dispositif d'affichage (6), comprenant les étapes suivantes :
a) agencement d'une carte à circuits imprimés à analyser (1) dans la zone de palpage (12) de la caméra (4), une image (25) de la caméra et une image (24) de la carte à circuits imprimés indépendante de l'image (25) de la caméra étant représentée à la même échelle sur le dispositif d'affichage (6),
b) translation de la carte à circuits imprimés à analyser (1) pour amener le plus amplement que possible l'image (25) de la caméra en chevauchement avec l'image (24) de la carte à circuits imprimés,
c) agrandissement de l'image de la caméra et de l'image de la carte à circuits imprimés dans le même rapport sur le dispositif d'affichage (6),
d) amenée en chevauchement plus exact de l'image (25) de la caméra par rapport à l'image de la carte à circuits imprimés, et
e) affichage de la zone prédéterminée à analyser, de sorte que la zone prédéterminée de la carte à circuits imprimés à analyser (1) est reconnaissable en illustration agrandie sur le dispositif d'affichage (6).

2. Procédé selon la revendication 1, **caractérisé en ce que** l'amenée en chevauchement plus exact de l'image (25) de la caméra par rapport à l'image (24) de la carte à circuits imprimés s'effectue par translation de la carte à circuits imprimés (1).

3. Procédé selon la revendication 1, **caractérisé en ce que** l'amenée en chevauchement plus exact de l'image (25) de la caméra par rapport à l'image (24) de la carte à circuits imprimés s'effectue au moyen d'un procédé automatique de reconnaissance d'image qui analyse l'image (25) de la caméra et qui l'amène automatiquement en chevauchement avec l'image (24) de la carte à circuits imprimés.

4. Procédé selon l'une des revendications 1 à 3, **caractérisé en ce que** dans une portion prédéterminée du dispositif d'affichage (18), l'image (24) de la carte à circuits imprimés est illustrée de telle sorte que la zone prédéterminée à analyser est agencée approximativement au milieu dans la portion (18) du dispositif d'affichage (6).

5. Procédé selon l'une des revendications 1 à 4, **caractérisé en ce que** la zone prédéterminée à analyser correspond à un défaut de la carte à circuits imprimés qui a été constaté auparavant au moyen d'un dispositif (2) de test de carte à circuits imprimés.

6. Procédé selon la revendication 5, **caractérisé en ce que** la zone prédéterminée à analyser dans l'image (24) de la carte à circuits imprimés est fixée par un point respectif de test de la carte à circuits imprimés qui est connecté à une piste conductrice de la carte à circuits imprimés qui a été jugée défectueuse par les mesures exécutées auparavant sur le dispositif (2) de test de la carte à circuits imprimés, et qui est indiquée par une flèche (21, 22) dont les pointes se terminent par le point de test de la carte à circuits imprimés.

7. Procédé selon la revendication 5, **caractérisé en ce que** la zone à analyser correspond à un tronçon d'une piste conductrice jugée comme défectueuse, ledit tronçon étant susceptible d'être représenté sur le dispositif d'affichage, plusieurs tronçons voisins de la piste conductrice étant successivement amenés à la représentation de façon agrandie sur le dispositif par répétition des étapes a) à e).

8. Procédé selon l'une des revendications 5 à 7, **caractérisé en ce qu'**après les mesures exécutées dans le dispositif de test de la carte à circuits imprimés, on génère un fichier de défaut qui présente une liste de tous les défauts mesurés, et **en ce que** par actionnement d'une seule touche, les étapes a) et c) sont susceptibles d'être appelées à répétition, de sorte que toutes les zones à analyser sont amenées à l'affichage de façon agrandie sur le dispositif d'affichage uniquement par translation de la carte à circuits imprimés (1) et par actionnement de la touche (9).

9. Procédé selon la revendication 8, **caractérisé en ce que** l'on utilise à titre de touche une touche à pied (9).

10. Procédé selon l'une des revendications 1 à 9, **caractérisé en ce que** l'étape c) de l'agrandissement de l'image de la caméra et de l'image de la carte à circuits imprimés et de la translation de la carte à circuits imprimés à analyser est répétée deux fois ou trois fois pour chaque zone à analyser, le facteur d'agrandissement pour chaque agrandissement de l'image de la caméra et de l'image de la carte à circuits imprimés n'est pas supérieur à 20.

11. Procédé selon l'une des revendications 1 à 10, **caractérisé en ce que** sur le dispositif d'affichage (6) sont prévues deux portions (17, 18), telle que dans une portion (18) on affiche l'image (24) de la carte à circuits imprimés et l'image (25) de la caméra, et dans l'autre portion (17) on affiche une image (26) de la carte à circuits imprimés à la même échelle que celle de l'image (24) de la carte à circuits imprimés et de l'image (25) de la caméra, image (26) dans laquelle sont illustrés aussi bien des points de test de la carte à circuits imprimés que des pistes conductrices.

12. Procédé selon l'une des revendications 1 à 11, **caractérisé en ce que** l'on utilise un dispositif comportant
- une caméra stationnaire (4),
- un dispositif d'affichage (6) qui est connecté à la caméra (4) pour afficher à la même échelle une image (24) de la carte à circuits imprimés et une image (25) saisie par la caméra d'une carte à circuits imprimés à analyser (1),
- un dispositif pour agrandir l'image de la caméra et l'image de la carte à circuits imprimés dans le même rapport sur le dispositif d'affichage (6).

13. Procédé selon la revendication 12, **caractérisé en ce que** le dispositif comprend un ordinateur (7) pourvu d'une unité de calcul centrale (14), d'une mémoire de données et de programme (15) et d'un écran (6) qui représente le dispositif d'affichage.

14. Procédé selon l'une ou l'autre des revendications 12 et 13, **caractérise en ce que** le dispositif est connecté à un dispositif (2) de test de carte à circuits imprimés via une ligne de données pour transmettre un ficher de défaut.

15. Procédé selon l'une des revendications 12 à 14, **caractérisé en ce que** la caméra comprend un objectif à zoom dont la focale est susceptible d'être pilotée par voie électrique.

16. Procédé selon l'une des revendications 12 à 15, **caractérisé en ce que** la caméra comprend un dispositif de focalisation.

17. Dispositif pour mettre en oeuvre le procédé selon l'une des revendications 1 à 11, comportant
- une caméra stationnaire (4),
- un dispositif d'affichage (6) qui est connecté à la caméra (4) pour afficher à la même échelle une image (24) de la carte à circuits imprimés et une image (25) saisie par la caméra d'une carte à circuits imprimés à analyser (1),
- un dispositif pour agrandir l'image de la caméra et l'image de la carte à circuits imprimés dans le même rapport sur le dispositif d'affichage (6),
le dispositif étant connecté à un dispositif (2) de test de carte à circuits imprimés via une ligne de données pour transmettre un fichier de défaut.

18. Dispositif selon la revendication 17, **caractérisé par** un ordinateur (7) pourvu d'une unité de calcul centrale (14), d'une mémoire de données et de programme (15) et d'un écran (6) qui représente le dispositif d'affichage.

19. Dispositif selon l'une ou l'autre des revendications 17 et 18, **caractérise en ce que** la caméra comprend un objectif à zoom dont la focale est susceptible d'être pilotée par voie électrique.

20. Dispositif selon l'une des revendications 17 à 19, **caractérisé en ce que** la caméra comprend un dispositif de focalisation.
